# DEMANDE DE BREVET EUROPEEN

(11) **EP 3 181 006 A1**
(43) Date de publication de la demande: **21.06.2017**
(21) Numéro de dépôt: 15201251.4
(22) Date de dépôt: 18.12.2015
(51) Int. Cl.: A44C 27/00, G04B 37/22

(54) **ELEMENT D'HABILLAGE EN ZIRCONE A COLORATION SELECTIVE**

(71) Demandeur: The Swatch Group Research and Development Ltd., 2074 Marin (CH)
(72) Inventeur: Curchod, Loïc, 1004 Lausanne (CH); Faure, Cédric, 2016 Cortaillod (CH); Willemin, Michel, 2515 Prêles (CH); Springer, Simon, 3007 Bern (CH)
(74) Mandataire: Goulette, Ludivine

(57) **Abrégé**

Élément d'habillage, pour objet portable, réalisé dans un premier matériau, le premier matériau étant un matériau céramique présentant une première couleur, caractérisé en ce que la surface dudit élément d'habillage est au moins partiellement traitée de sorte à présenter au moins une transformation pourvue d'une couleur différente de la première couleur.

## Description

La présente invention concerne un élément d'habillage et son procédé de fabrication réalisé en céramique du type zircone dont la coloration est modifiée sélectivement.

### ART ANTERIEUR

Il est connu des objets portables comme des montres, des bijoux ou des bracelets qui sont en partie réalisés en céramique. Une céramique connue est la zircone ZrO₂.

Actuellement, il est possible d'avoir une coloration de cette zircone en la teintant dans la masse via des pigments blancs ou noirs ou en la teintant en surface via un procédé de carburation transformant la surface de la zircone sur une certaine profondeur en une couche de carbure de zirconium. Cette couche de carbure de zirconium confère un aspect brillant de couleur platine à l'élément d'habillage.

En outre, il est connu un procédé de nitruration, similaire audit procédé de carburation, permettant de transformer la surface de la zircone sur une certaine profondeur en une couche de nitrure de zirconium conférant un aspect brillant de couleur proche de l'or jaune à l'élément d'habillage.
Or, actuellement, les pièces en zircone colorées sont teintées de manière uniforme c'est-à-dire que toute la surface est teintée et non pas une zone. L'inconvénient est donc que les méthodes actuelles ne permettent pas une variation de coloris et donc la création de motifs à but esthétique ou fonctionnel.

### RESUME DE L'INVENTION

La présente invention a pour but de pallier les inconvénients de l'art antérieur en proposant un élément d'habillage en céramique et son procédé de fabrication qui permettent une variation de coloris et donc la création de motifs.

A cet effet, l'invention concerne un élément d'habillage pour un objet portable réalisé dans un premier matériau, le premier matériau étant un matériau céramique présentant une première couleur, caractérisé en ce qu'au moins une surface dudit élément d'habillage est au moins partiellement traitée de sorte à présenter une transformation pourvue d'une coloration différente de la première couleur.

Cette invention permet d'avoir un élément d'habillage qui est coloré en profondeur c'est-à-dire donc la coloration n'est pas superficielle et ne peux donc pas être effacé facilement.

Dans un premier mode de réalisation, le premier matériau est de la zircone.

Dans un second mode de réalisation, la surface est sélectivement traitée pour être transformée en carbure.

Dans un troisième mode de réalisation, la surface est sélectivement traitée pour être transformée en nitrure.

Dans un quatrième mode de réalisation, la surface est sélectivement traitée pour présenter un dépôt métallique en des zones localisées.

Dans un cinquième mode de réalisation, la surface comprend au moins une creusure, la surface étant traitée pour être transformée en carbure ou nitrure, puis polie pour localiser cette transformation au niveau de ladite creusure.

Dans un sixième mode de réalisation, la surface comprend au moins une partie saillante, la surface étant traitée pour être transformée en carbure ou nitrure, puis polie pour exclure cette transformation de ladite partie saillante.

Dans un septième mode de réalisation, la surface est transformée en carbure ou nitrure de manière homogène, puis usinée localement pour localiser la transformation sur les parties non-usinées.

Dans un huitième mode de réalisation, la surface est sélectivement traitée pour subir la diffusion d'un pigment sur ladite surface de l'élément d'habillage.

La présente invention concerne aussi un objet portable comprenant l'élément d'habillage selon l'une des revendications précédentes.

Dans un premier mode de réalisation, ledit objet portable est une pièce d'horlogerie comprenant un boitier formé par une carrure fermée par un fond et une glace, potentiellement munie d'une lunette et de boutons et/ou d'une couronne, et un bracelet fixé à la carrure via deux paires de cornes, et en ce que l'élément d'habillage est choisi pour être agencé dans la liste comprenant la carrure, la lunette, le cadran, les boutons, la couronne, le fond, le bracelet, la boucle.

La présente invention concerne en outre un procédé de traitement d'un élément d'habillage pour un objet portable réalisé dans un premier matériau, le premier matériau étant un matériau céramique présentant une première couleur, ledit procédé comprenant les étapes suivantes :
- Se munir de l'élément d'habillage et le placer dans une enceinte fermée hermétiquement et contenant une atmosphère chargée atomiquement d'un élément chimique ;
- Chauffer localement, par l'intermédiaire d'une première source de chaleur focalisée comme par exemple un laser, la surface de l'élément d'habillage de sorte que les atomes de l'atmosphère de l'enceinte se combinent localement avec la surface du premier matériau à l'endroit où ladite surface est chauffée.

Dans un premier mode de réalisation, l'atmosphère est créée par dissociation d'un gaz via la même source de chaleur chauffant localement la surface de l'élément d'habillage.

Dans un deuxième mode de réalisation, l'atmosphère est créée par dissociation d'un gaz via une seconde source de chaleur indépendante de celle qui chauffe localement la surface de l'élément d'habillage.

Dans un troisième mode de réalisation, l'atmosphère est créée par dissociation d'un gaz via une deuxième source de chaleur indépendante de la première source qui chauffe localement la surface de l'élément d'habillage, l'élément d'habillage étant chauffé de manière homogène via une troisième source de chaleur à une température plus faible que celle permettant la combinaison des atomes de l'atmosphère avec le premier matériau, la première source de chaleur servant à élever localement la température de la surface de l'élément d'habillage afin de permettre la combinaison des atomes de l'atmosphère avec le premier matériau.

Dans une première variante, ledit procédé comprend les étapes suivantes :
- Se munir de l'élément d'habillage ;
- Déposer localement sur la surface dudit élément d'habillage une couche métallique ;
- Placer ledit élément d'habillage dans une enceinte fermée hermétiquement et contenant une atmosphère chargée atomiquement d'un élément chimique et chauffer la surface de l'élément d'habillage de sorte que les atomes de l'atmosphère de l'enceinte se combinent avec la surface du premier matériau non recouverte du dépôt métallique.

Dans un premier mode de réalisation, le procédé comprend en outre une étape consistant à attaquer sélectivement et chimiquement la surface dudit élément d'habillage afin de retirer le dépôt métallique localement, avant la carburation ou nitruration de la surface dudit élément d'habillage.

Dans un second mode de réalisation, le dépôt métallique sélectif est réalisé par dépôt au travers d'un masque préalablement posé sur l'élément d'habillage.

Dans un troisième mode de réalisation, l'étape consistant à déposer une couche métallique sélective consiste à déposer une couche d'épargne sur la totalité de la surface dudit élément d'habillage puis à graver sélectivement cette couche d'épargne selon une forme désirée puis à déposer la couche métallique sur la totalité de la surface dudit élément d'habillage. La couche d'épargne restante est ensuite enlevée par attaque chimique, ne laissant la couche métallique qu'aux endroits où la couche d'épargne a été sélectivement gravée.

Dans un quatrième mode de réalisation, le dépôt métallique sélectif est réalisé par dépôt suivi d'une étape de structuration par laser de la surface dudit élément d'habillage.

Dans un cinquième mode de réalisation, le dépôt métallique sélectif est réalisé par dépôt suivi d'une étape de photolithographie de la surface dudit élément d'habillage.

Dans une seconde variante, ledit procédé comprend les étapes suivantes :
- Se munir de l'élément d'habillage ;
- Traiter ledit élément d'habillage en le plaçant dans une enceinte fermée hermétiquement et contenant une atmosphère chargée atomiquement d'un élément chimique et en chauffant sa surface de sorte que les atomes de l'atmosphère de l'enceinte se combinent avec la surface du premier matériau.
caractérisé en ce que ledit procédé comprend en outre, préalablement ou postérieurement à l'étape consistant à traiter ledit élément d'habillage, une étape de structuration de l'élément d'habillage permettant la création de relief sur sa surface.

Dans un premier mode de réalisation, lorsque l'étape de structuration de l'élément d'habillage est réalisée postérieurement à l'étape consistant à traiter la surface dudit élément d'habillage, la structuration ôte la couche superficielle sur les zones structurées et révèle ainsi localement la couleur du coeur dudit élément d'habillage en zircone.

Dans un second mode de réalisation, le procédé comprend en outre, lorsque l'étape de structuration de l'élément d'habillage est réalisée antérieurement à l'étape consistant à traiter la surface dudit élément d'habillage, une étape de polissage pour enlever la couche superficielle sur la partie haute de la surface en relief de l'élément d'habillage et révéler ainsi localement la couleur du coeur dudit élément d'habillage en zircone.

Dans une troisième variante, ledit procédé comprend les étapes suivantes :
- Se munir de l'élément d'habillage ;
- Déposer un second matériau sur la surface dudit élément d'habillage; ledit second matériau comprenant des pigments de couleur ;
- Chauffer l'élément d'habillage de sorte à faire fondre ou diffuser les pigments dans la surface de l'élément d'habillage.

Dans un premier mode de réalisation, ladite étape consistant à chauffer l'élément d'habillage est opérée dans une enceinte fermée hermétiquement et contenant une atmosphère chargée atomiquement d'un élément chimique de sorte que les atomes de l'atmosphère de l'enceinte se combinent avec la surface du premier matériau non recouverte par le second matériau.

### BREVE DESCRIPTION DES FIGURES

Les buts, avantages et caractéristiques de l'invention apparaîtront plus clairement dans la description détaillée suivante d'au moins une forme de réalisation de l'invention donnée uniquement à titre d'exemple non limitatif et illustrée par les dessins annexés sur lesquels :
- Les figures 1 et 2 représentent schématiquement l'objet portable selon l'invention;
- Les figures 3 à 5 représentent schématiquement un premier mode de réalisation du procédé selon l'invention;
- Les figures 6 à 20 représentent schématiquement un second mode de réalisation du procédé selon l'invention;
- Les figures 21 et 22 représentent schématiquement un troisième mode de réalisation du procédé selon l'invention;
- Les figures 23 et 24 représentent schématiquement un quatrième mode de réalisation du procédé selon l'invention.

### DESCRIPTION DETAILLEE

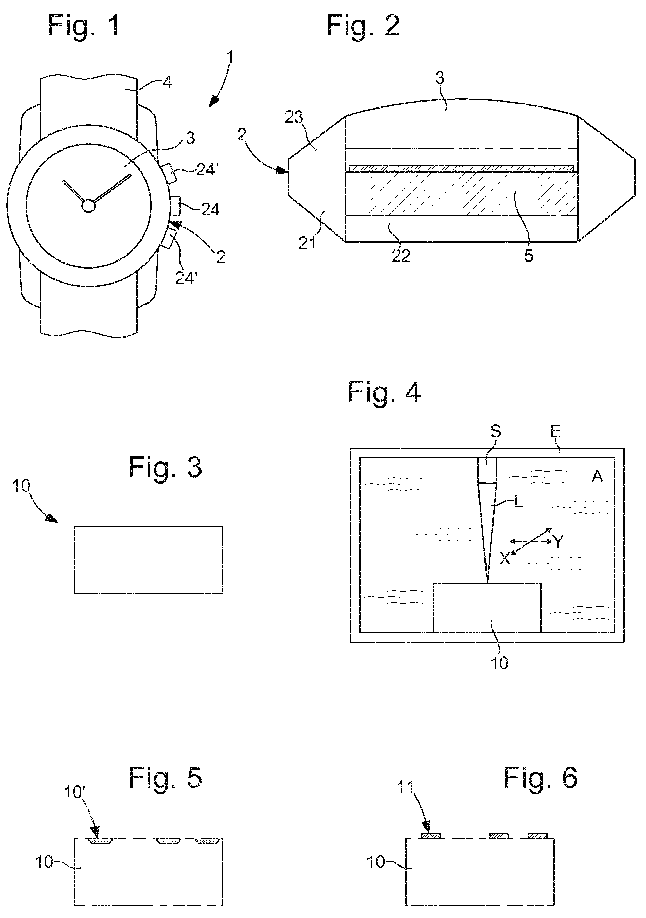

Sur les figures 1 et 2, un objet portable 1 selon l'invention est décrit. Un exemple d'objet portable selon l'invention est une pièce d'horlogerie. Une telle pièce d'horlogerie comprend un boitier 2 formé par une carrure 21 fermée par un fond 22 et une glace 3. Ce boitier 2 renferme un mouvement horloger 5 électronique ou mécanique ou électromécanique. Cette objet portable peut également comprendre un bracelet 4 comprenant deux brins 4' ou une pluralité de maillons. Un élément d'habillage selon l'invention est donc compris dans la liste comprenant la carrure, le fond, le bracelet, la boucle déployante ou la boucle - ardillon nécessaire à la fermeture du bracelet. Bien entendu, la montre peut également comprendre une lunette 23, tournante ou non, intégrée ou non à la carrure, ainsi que des moyens de commande comme une tête de couronne 24 ou des boutons-poussoirs 24'. La carrure 21 pourra être munie d'une lunette intégrée ou rapportée.

L'élément d'habillage selon l'invention est réalisé dans un premier matériau. Ce matériau est choisi pour être du type céramique. La céramique utilisée ici est de l'oxyde de zirconium ZrO₂ également appelé zircone.

Avantageusement selon l'invention, cet élément d'habillage 10 en céramique est traité en surface. Ce traitement en surface est opéré de sorte à être sélectif c'est-à-dire que l'élément d'habillage n'est pas obligatoirement traité sur l'intégralité de sa surface. Ce traitement de surface est utilisé afin d'obtenir une diversité de couleur améliorée ou d'avoir une possibilité de décoration supérieure avec des motifs.

Dans un premier mode de réalisation visible aux figures 3 à 5, le traitement selon la présente invention consiste en une carburation/nitruration sélective de l'élément d'habillage 10 par une source de chaleur focalisée, comme un laser. Pour rappel, une carburation/nitruration consiste à activer la pièce à se carburer/nitrurer en la chauffant dans une atmosphère chargée en atomes de carbone ou d'azote.

La première étape consiste donc à se munir de l'élément d'habillage 10 qui sera traité et à le placer dans une enceinte E. Cette enceinte E est fermée hermétiquement et contient une atmosphère A chargée en atomes de carbone C ou d'azote N suivant que l'on pratique une carburation ou une nitruration. Cette atmosphère A chargée en atomes de carbone C ou d'azote N peut être créée par dissociation de composés tels que le méthane CH₄, le diazote N₂ ou l'ammoniac NH₃. Cette dissociation est opérée en chauffant les composés de base pour briser les liaisons moléculaires et obtenir des atmosphères atomiques.

La seconde étape consiste à carburer ou nitrurer sélectivement l'élément d'habillage 10 en activant par chauffage la surface de la pièce dans des zones choisies 10'. Pour pouvoir chauffer sélectivement ladite surface dans les zones choisies 10', une source de chaleur focalisée S, e.g. un laser fournissant un faisceau laser L, est utilisée. Ce faisceau laser est préférentiellement pulsé. La surface de l'élément d'habillage 10 est alors chauffée localement dans les zones 10' à une température comprise entre 700 et 1100°C pendant une durée de 30 à 180 minutes. Sous l'effet de cette température les atomes de carbone ou d'azote de l'atmosphère A de l'enceinte E se combinent avec la surface en zircone dans les zones 10' de l'élément d'habillage 10. Il s'agit d'une transformation de la surface des zones 10' de l'élément d'habillage 10 sur une faible épaisseur, de l'ordre de 10 à 500 nm, en carbure de zirconium ou nitrure de zirconium ayant un aspect métallique de couleur platine ou proche de l'or jaune respectivement. Il s'agit donc d'une modification superficielle de la structure de la zircone en une nouvelle structure cristallographique correspondant à celle du carbure de zirconium/nitrure de zirconium et non d'un revêtement rapporté susceptible d'être arraché ou de se désolidariser de la surface de l'article, notamment lorsque celui-ci est soumis à des conditions d'usure importante ou de chocs. Plus particulièrement, la couche superficielle qui présente la structure du carbure de zirconium ou du nitrure de zirconium s'étend à partir de la surface sur une profondeur comprise entre 10 et 500 nm.

Pour opérer les différentes étapes, il peut être prévu plusieurs modes d'exécution.

Dans un premier mode d'exécution, la dissociation des gaz pour obtenir une atmosphère chargée en atomes de carbone C ou d'azote N et l'activation locale de la surface dudit l'élément d'habillage 10 utilisent le même laser.

Dans un second mode d'exécution, la dissociation des gaz pour obtenir une atmosphère chargée en atomes de carbone C ou d'azote N est opérée par une première source de chaleur alors que l'activation locale de la surface de l'élément d'habillage 10 utilise le laser.

Dans un troisième mode d'exécution, la dissociation des gaz pour obtenir une atmosphère chargée en atomes de carbone C ou d'azote N est opérée par une première source de chaleur, l'élément d'habillage est chauffé via une seconde source de chaleur alors que l'activation locale de la surface de l'élément d'habillage utilise le laser. Ce troisième mode d'exécution permet de préchauffer l'élément d'habillage 10 de manière homogène et d'avoir un écart de température moins élevé dans la zone de la surface de l'élément d'habillage 10 traitée par la source de chaleur focalisée.

Un avantage de ce premier mode de réalisation est qu'il permet aisément une activation sélective de la surface de l'élément d'habillage 10. En effet, un faisceau laser présente l'avantage d'avoir un diamètre de faisceau réglable.

Dans un second mode de réalisation visible aux figures 6 à 20, le principe utilisé est une métallisation sélective.

La première étape consiste donc à se munir de l'élément d'habillage 10 et de lui apposer une métallisation 11 sur sa surface. Cette métallisation 11 est sélective c'est-à-dire qu'elle est effectuée sur la ou les zones que l'on désire ne pas carburer ou nitrurer. Ce dépôt métallique est réalisé par exemple dans un matériau compris dans la liste incluant le Chrome, le Tantale, le Molybdène, le Tungstène, le Niobium, le Titane, le Silicium, le Bore et est réalisé selon plusieurs modes d'exécution.

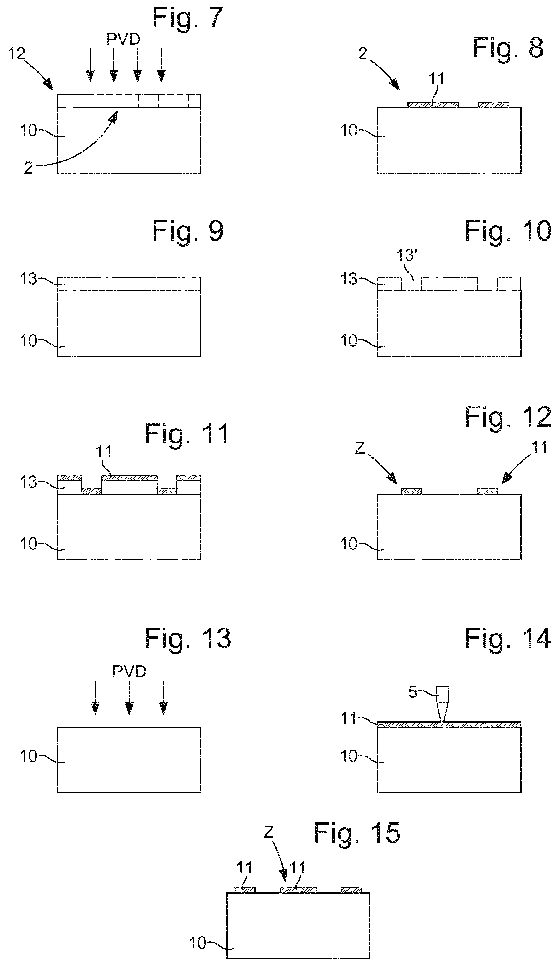

Dans un premier mode d'exécution visible aux figures 7 et 8, la métallisation est réalisée par masquage de la surface de l'élément d'habillage 10 via un masque 12 suivi par une déposition métallique via un procédé du type dépôt physique en phase vapeur PVD. Ainsi, seules les zones Z non recouvertes par le masque reçoivent le dépôt de métal 11.

Dans un second mode d'exécution visible aux figures 9 à 12, la métallisation est réalisée en déposant une couche d'épargne 13 comme une couche de capton ou une couche d'encre ou de laque ou de résine sur la surface de l'élément d'habillage. Cette couche 13 est alors sélectivement gravée selon l'esthétisme voulu et laisse apparaitre des ouvertures 13'. Le tout est alors recouvert d'une couche métallique 11 par dépôt PVD, la couche se déposant tant sur la couche d'épargne 13 que dans les creusures 13' faites dans ladite épargne. Enfin la couche d'épargne 13 est enlevée par attaque chimique, laissant la couche métallique 11 uniquement sur les zones Z correspondant aux endroits des creusures 13' de l'épargne retirée.

Dans un troisième mode d'exécution visible aux figures 13 à 15, le dépôt métallique sélectif consiste à déposer le métal 11 sur la totalité de la surface de l'élément d'habillage 10 pour ensuite utiliser une source de chaleur focalisée S tel un laser pour structurer la couche métallique 11 déposée. Cette structuration consiste en un décapage de la surface de l'élément d'habillage 10 pour enlever la couche métallique 11 aux endroits non désirés et laissant la couche métallique 11 sur les zones désirées Z.

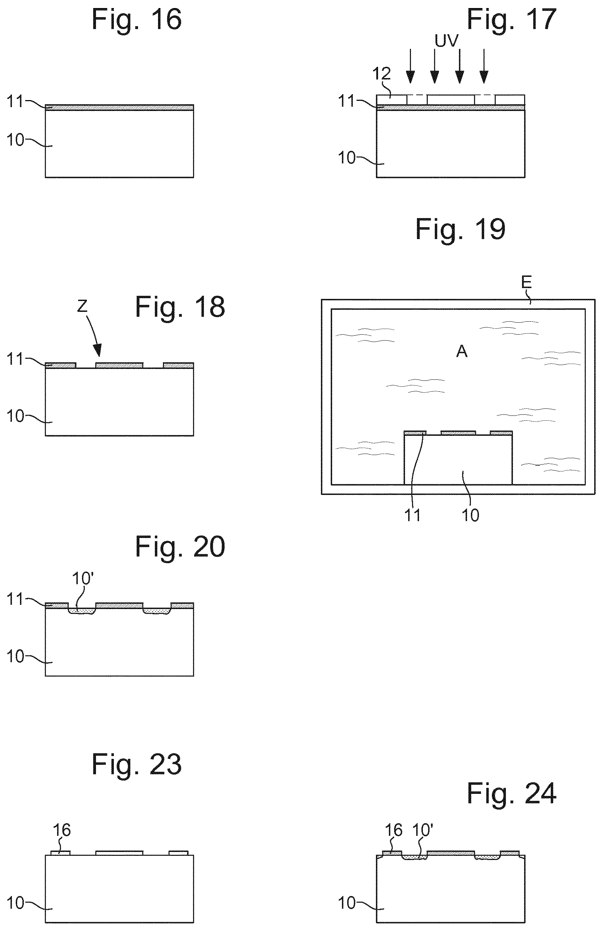

Dans un quatrième mode d'exécution visible aux figures 16 à 18, le dépôt métallique sélectif consiste à déposer le métal sur la totalité de la surface de l'élément d'habillage 10. Suite à cela, une étape de photolithographie avec un masque 12 est utilisée pour modifier localement la couche métallique déposée. Cette modification locale est suivie d'une étape d'attaque chimique pour enlever la couche métallique 11 aux endroits non désirés et la laisser sur les zones désirées Z.

Une fois ce dépôt métallique réalisé, l'étape suivante consiste à carburer ou nitrurer l'élément d'habillage 10 avec la couche métallique 11 sur les zones Z de sa surface. Pour cela, l'élément d'habillage 10 est placé dans une enceinte E qui contient une atmosphère A chargée en atomes de carbone C ou d'azote N, comme indiqué à la figure 19. Le tout est alors chauffé en utilisant une technique plasma telle que décrite dans le brevet EP 0 850 900. Or, le dépôt métallique 11 fait ici office de bouclier empêchant la carburation/nitruration des zones recouvertes par cette couche métallique 11 et permettant la transformation aux zones 10' non recouvertes comme visible à la figure 20.

Dans le cas où l'élément d'habillage 10 est réalisé en zircone blanche, la réduction opérée lors de ladite carburation/nitruration entraine l'apparition d'une couleur grise de la zircone sous la couche PVD. Dans le cas d'une zircone noire, l'élément d'habillage 10 garde sa couleur noire permettant une étape supplémentaire dans laquelle le dépôt métallique 11 est chimiquement dissous pour laisser apparaitre la zircone dans sa couleur noire. On obtient donc un contraste entre la zircone noire et le reste de l'élément d'habillage 10 carburé ou nitruré.

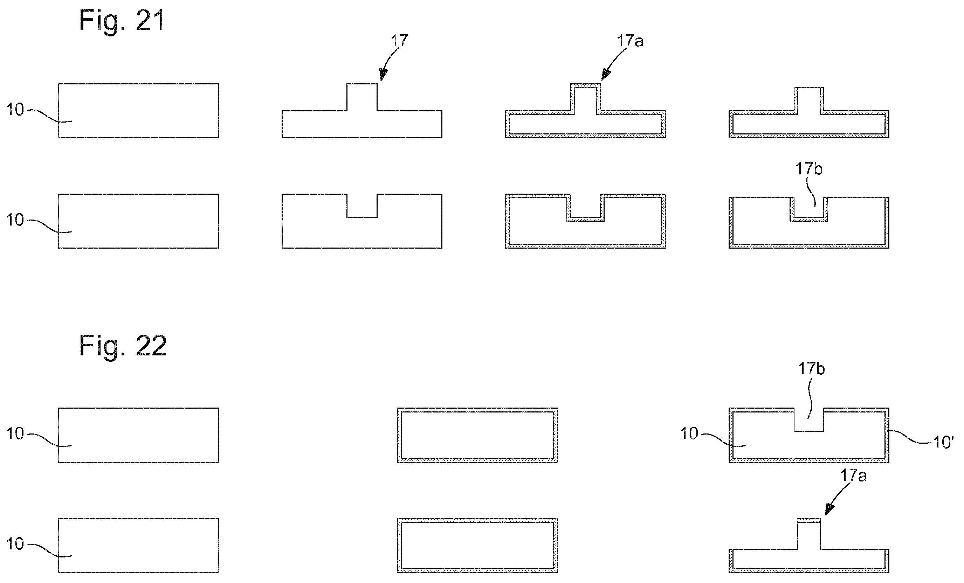

Dans un troisième mode de réalisation visible aux figures 21 et 22, la coloration sélective de l'élément d'habillage 10 utilise le principe de carburation/nitruration et de structuration.

Dans un premier mode d'exécution visible à la figure 21, la première étape consiste à se munir de l'élément d'habillage 10 en zircone. Préférentiellement, la zircone utilisée est la zircone noire. Cette première étape consiste également à structurer cet élément d'habillage. Cette structuration peut être opérée de deux manières différentes : Durant la fabrication de l'élément d'habillage ou postérieure à cette fabrication. Ces structurations 17 se présentent sous la forme de creux 17b ou de parties saillantes 17a.

Dans le cas où la structuration est réalisée pendant la fabrication de l'élément d'habillage 10, on comprendra que cette fabrication consiste à mélanger entre elles des poudres pour ensuite les mettre dans un moule et les fritter c'est à dire les soumettre à une température et une pression telle qu'une transformation s'opère. Ainsi, le moule dans lequel les poudres sont placées peut avoir une forme incluant les structurations 17 désirées.

Dans le cas où la structuration est réalisée postérieurement à la fabrication de l'élément d'habillage 10, un usinage mécanique ou laser est envisageable.

Dans une seconde étape, l'élément d'habillage est carburé ou nitruré. Pour cela, l'élément d'habillage 10 structuré est placé dans une enceinte E dans laquelle se trouve une atmosphère A chargée en atomes de carbone ou d'azote. Le tout est alors chauffé via un plasma durant une durée déterminée afin de transformer la surface de l'élément d'habillage en carbure ou nitrure de zirconium respectivement. Cette carburation/nitruration est donc réalisée sur la totalité de la surface de l'élément d'habillage 10.

Dans une troisième étape, l'élément d'habillage 10 subit une étape de polissage. Cette étape de polissage consiste à enlever la couche superficielle de l'élément d'habillage. Or, l'élément d'habillage est munie de structurations 17 se présentant sous la forme de creux 17b ou de parties saillantes 17a, ces creux 17b ou parties saillantes 17a étant eux aussi carburés/nitrurés. Par conséquent, le polissage ne concerne pas l'intégralité de la surface de l'élément d'habillage 10. Effectivement, dans le cas où les structurations 17 sont des creusures 17b, l'opération de polissage laisse la carburation/nitruration dans les creusures. Dans le cas où les structurations 17 sont des parties saillantes 17a, l'opération de polissage enlève la carburation/nitruration au niveau de ces parties saillantes 17a.

Ainsi, on obtient un contraste entre la partie polie de l'élément d'habillage 10 et la partie carburée/nitrurée.

Dans un second mode d'exécution visible à la figure 22, la première étape consiste à se munir de l'élément d'habillage 10 en zircone.

Dans une seconde étape, ledit élément d'habillage est carburé/nitruré. Pour cela, l'élément d'habillage 10 structuré est placé dans une enceinte E dans laquelle se trouve une atmosphère A chargée en atomes de carbone ou d'azote. Le tout est alors chauffé via un plasma durant une durée déterminée afin de transformer la surface de l'élément d'habillage en carbure ou nitrure de zirconium respectivement. Cette carburation/nitruration est donc réalisée sur la totalité de la surface de l'élément d'habillage 10.

Dans une troisième étape, l'élément d'habillage 10 subit une étape de structuration. Cette étape consiste à enlever de la matière de l'élément d'habillage. Pour cela, un usinage mécanique ou laser est utilisé. L'enlèvement de matière peut être opéré de sorte à n'enlever localement que la couche superficielle de 10 à 500 nm qui est transformée en carbure ou nitrure de zirconium. Toutefois, l'enlèvement de matière peut être opéré de sorte à créer une creusure visible afin d'associer le contraste à un relief, ce relief pouvant accentuer ledit contraste.

Dans un quatrième mode de réalisation visible aux figures 23 et 24, la coloration sélective de l'élément d'habillage 10 utilise des pigments, par exemple des émaux ou des encres. Ce mode de réalisation consiste dans une première étape à se munir de l'élément d'habillage 10.

Dans une seconde étape, il est nécessaire de se munir d'encres ou d'émaux colorés 16. Ces émaux se présentent sous la forme d'une huile comprenant une poudre de pigments colorés.

Ces encres ou émaux 16 sont alors disposés sur la surface de l'élément d'habillage 10 selon le motif désiré. Pour cela, une machine d'impression est utilisée.

Dans une troisième étape, l'élément d'habillage 10 muni du dépôt sélectif d'encres ou d'émaux 16 subit une étape de diffusion. Cette étape de diffusion consiste à chauffer l'élément d'habillage pour fixer la couleur.

Selon un premier mode d'exécution, l'étape de diffusion consiste en un recuit pour fixer la couleur. Ce recuit consiste à passer l'élément d'habillage dans un four. Pour les émaux, la température du four atteint les 800°C. À cette température, l'huile dans laquelle les pigments sont en suspension s'évapore alors que les pigments sont fondus en surface ou diffusent dans la surface de l'élément d'habillage.

Selon un second mode d'exécution, l'étape de diffusion consiste en une carburation/nitruration. Cette étape consiste alors à placer l'élément d'habillage 10 muni du dépôt sélectif d'encres ou d'émaux 16 dans une enceinte E fermée hermétiquement et contenant une atmosphère A chargée en atomes de carbone C ou d'azote N suivant que l'on pratique une carburation ou nitruration respectivement. La surface de la pièce est activée par chauffage plasma à une température comprise entre 700 et 1100°C pendant une durée déterminée. Sous l'effet de cette température les atomes de carbone ou d'azote de l'atmosphère A de l'enceinte E se combinent avec la surface en zircone de l'élément d'habillage 10. Il s'agit d'une transformation de l'élément d'habillage sur une faible épaisseur, de l'ordre de 10 à 500 nm, la zircone (oxyde de zirconium) dans la région extérieure de l'élément d'habillage étant transformée en carbure de zirconium ou nitrure de zirconium ayant un aspect métallique de couleur platine ou proche de l'or jaune respectivement. Simultanément, la chaleur du four permet également de chauffer les encres ou les émaux 16 de sorte à les faire fondre en surface ou les faire diffuser dans la surface de l'élément d'habillage 10. On se retrouve donc avec un élément d'habillage 10 dont la surface est carburée ou nitrurée dans les zones 10' et colorée sur les zones sur lesquelles les encres ou les émaux 16 étaient déposés comme visible à la figure 24.

Cette technique permet avantageusement d'avoir un contraste entre la partie carburée/nitrurée et la partie colorée.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention définie par les revendications annexées.

Ainsi, on comprendra que l'élément d'habillage peut être traitée à différents endroits sur sa surface.

## Revendications

1. Elément d'habillage (10) pour objet portable (1) réalisé dans un premier matériau, le premier matériau étant un matériau céramique présentant une première couleur, **caractérisé en ce qu'**au moins une surface dudit élément d'habillage est au moins partiellement traitée de sorte à présenter au moins une transformation (10') pourvue d'une coloration différente de la première couleur.

2. Elément d'habillage selon la revendication 2, **caractérisé en ce que** le premier matériau est de la zircone.

3. Elément d'habillage selon les revendications 1 ou 2, **caractérisé en ce que** la surface est sélectivement traitée pour être transformée en carbure.

4. Elément d'habillage selon les revendications 1 ou 2, **caractérisé en ce que** la surface est sélectivement traitée pour être transformée en nitrure.

5. Elément d'habillage selon l'une des revendications précédentes, **caractérisé en ce que** la surface est sélectivement traitée pour présenter un dépôt métallique (11).

6. Elément d'habillage selon l'une des revendications 1 à 4, **caractérisé en ce que** la surface comprend au moins une creusure (17b), la surface étant traitée pour être transformée en carbure ou nitrure, et polie pour localiser cette transformation au niveau de ladite creusure.

7. Elément d'habillage selon l'une des revendications 1 à 4, **caractérisé en ce que** la surface comprend au moins une partie saillante (17a), la surface étant traitée pour être transformée en carbure ou nitrure et polie pour exclure cette transformation de ladite partie saillante.

8. Elément d'habillage selon l'une des revendications 1 à 4, **caractérisé en ce que** la surface est sélectivement traitée pour subir le dépôt ou la diffusion de pigments (16) sur ladite surface de l'élément d'habillage.

9. Objet portable comprenant l'élément d'habillage (10) selon l'une des revendications précédentes.

10. Objet portable selon la revendication 9, **caractérisé en ce que** ledit objet portable est une pièce d'horlogerie comprenant un boitier (2) formé par une carrure (21), munie d'une lunette, fermée par un fond (22) et une glace (3), ledit objet portable comprenant en outre des moyens de commande (24, 24'), un cadran et un bracelet (4) avec fermoir et fixé à la carrure via deux paires de cornes, et **en ce que** l'élément d'habillage est choisi pour être agencé dans la liste comprenant la carrure, la lunette, le cadran, les moyens de commande, le fond, le bracelet et le fermoir.

11. Procédé de traitement d'un élément d'habillage (10) pour objet portable réalisé dans un premier matériau, le premier matériau étant un matériau céramique présentant une première couleur, ledit procédé comprenant les étapes suivantes :
• Se munir de l'élément d'habillage et le placer dans une enceinte (E) fermée hermétiquement et contenant une atmosphère chargée atomiquement d'un élément chimique ;
• Chauffer localement, par l'intermédiaire d'une première source de chaleur focalisée (S), la surface de l'élément d'habillage de sorte que les atomes de l'atmosphère de l'enceinte se combinent avec la surface du premier matériau.

12. Procédé de traitement selon la revendication 11, **caractérisé en ce que** l'atmosphère est créée par dissociation d'un gaz via une seconde source de chaleur.

13. Procédé de traitement selon la revendication 11, **caractérisé en ce que** l'atmosphère est créée par dissociation d'un gaz via une seconde source de chaleur, l'élément d'habillage étant chauffé à une température plus faible que la température d'activation de la combinaison des atomes de l'atmosphère avec la surface du premier matériau via une troisième source de chaleur.

14. Procédé de traitement d'un élément d'habillage (10) pour objet portable réalisé dans un premier matériau, le premier matériau étant un matériau céramique présentant une première couleur, ledit procédé comprenant les étapes suivantes :
• Se munir de l'élément d'habillage ;
• Déposer localement sur la surface dudit élément d'habillage une couche métallique (11);
• Placer ledit élément d'habillage dans une enceinte (E) fermée hermétiquement et contenant une atmosphère chargée atomiquement d'un élément chimique et chauffer la surface de l'élément d'habillage de sorte que les atomes de l'atmosphère de l'enceinte se combinent avec la surface du premier matériau non recouverte du dépôt métallique.

15. Procédé de traitement selon la revendication 14, **caractérisé en ce qu'**il comprend en outre une étape consistant à attaquer sélectivement et chimiquement la surface dudit élément d'habillage afin de retirer le dépôt métallique.

16. Procédé de traitement selon les revendications 14 ou 15, **caractérisé en ce que** le dépôt métallique sélectif est réalisé par dépôt au travers d'un masque (12) préalablement posé sur l'élément d'habillage.

17. Procédé de traitement selon les revendications 14 ou 15, **caractérisé en ce que** l'étape consistant à déposer une couche métallique consiste à déposer une couche d'épargne (13) sur la totalité de la surface dudit élément d'habillage puis à graver sélectivement cette couche d'épargne selon une forme désirée puis à déposer la couche métallique (11) sur la totalité de la surface dudit élément d'habillage, la couche d'épargne restante étant ensuite enlevée par attaque chimique, laissant ainsi la couche métallique aux endroits où la couche d'épargne était préalablement gravée.

18. Procédé de traitement selon les revendications 14 ou 15, **caractérisé en ce que** le dépôt métallique sélectif est réalisé par dépôt suivi d'une étape de structuration par laser de la surface dudit élément d'habillage.

19. Procédé de traitement selon les revendications 14 ou 15, **caractérisé en ce que** le dépôt métallique sélectif est réalisé par dépôt suivi d'une étape de photolithographie de la surface dudit élément d'habillage.

20. Procédé de traitement d'un élément d'habillage (10) pour objet portable réalisé dans un premier matériau, le premier matériau étant un matériau céramique présentant une première couleur, ledit procédé comprenant les étapes suivantes :
• Se munir de l'élément d'habillage ;
• Traiter ledit élément d'habillage en le plaçant dans une enceinte fermée hermétiquement et contenant une atmosphère chargée atomiquement d'un élément chimique et en chauffant sa surface de sorte que les atomes de l'atmosphère de l'enceinte se combinent avec la surface en premier matériau.
**caractérisé en ce que** ledit procédé comprend en outre, préalablement ou postérieurement à l'étape consistant à traiter ledit élément d'habillage, une étape de structuration de l'élément d'habillage permettant de créer un relief (17) sur sa surface et de révéler la couleur du premier matériau en contraste avec la couleur de la surface carburée ou nitrurée.

21. Procédé de traitement selon la revendication 20, **caractérisé en ce qu'**il comprend en outre, lorsque l'étape de structuration de l'élément d'habillage est réalisée antérieurement à l'étape consistant à traiter ledit élément d'habillage, une étape de polissage pour enlever la couche superficielle carburée/nitrurée sur les parties saillantes de la surface en relief de l'élément d'habillage.

22. Procédé de traitement d'un élément d'habillage (10) pour objet portable réalisé dans un premier matériau, le premier matériau étant un matériau céramique présentant une première couleur, ledit procédé comprenant les étapes suivantes :
• Se munir de l'élément d'habillage ;
• Déposer un second matériau (16) sur la surface dudit élément d'habillage; ledit second matériau comprenant des pigments de couleur ;
• Chauffer l'élément d'habillage de sorte à faire fondre ou diffuser les pigments dans la surface de l'élément d'habillage (10).

23. Procédé de traitement selon la revendication 22, **caractérisé en ce que** ladite étape consistant à chauffer l'élément d'habillage est opérée dans une enceinte fermée hermétiquement et contenant une atmosphère chargée atomiquement d'un élément chimique de sorte que les atomes de l'atmosphère de l'enceinte se combinent avec la surface du premier matériau non recouverte par le second matériau.
